# EUROPÄISCHE PATENTSCHRIFT

(11) **EP 1 004 226 B1**
(45) Veröffentlichungstag und Bekanntmachung des Hinweises auf die Patenterteilung: **08.05.2002**
(21) Anmeldenummer: 97925892.8
(22) Anmeldetag: 02.06.1997
(51) Int. Cl.: H05K 3/20, H05K 7/06

(54) **VERFAHREN UND VORRICHTUNG ZUR HERSTELLUNG VON DRAHTGESCHRIEBENEN LEITERPLATTEN**
METHOD AND DEVICE FOR PRODUCING WIRE-WRITTEN PRINTED CIRCUIT BOARDS
PROCEDE ET DISPOSITIF POUR PRODUIRE DES CARTES DE CIRCUITS A CABLAGE IMPRIME

(43) Veröffentlichungstag der Anmeldung: 31.05.2000
(73) Patentinhaber: Juma Leiterplattentechnologie GmbH, 90542 Eckental (DE)
(72) Erfinder: WOLFEL, Markus, 90542 Eckental (DE); GOTTLIEB, Jürgen, 91052 Erlangen (DE)
(74) Vertreter: Hanke, Hilmar
(86) Internationale Anmeldenummer: DE9701099
(87) Internationale Veröffentlichungsnummer: WO9856216

(56) Entgegenhaltungen:
- EP-A- 0 064 011
- EP-A- 0 703 646
- US-A- 4 450 623
- US-A- 5 345 978

## Beschreibung

Die Erfindung betrifft ein Verfahren und eine Vorrichtung zur Herstellung von drahtgeschriebenen Leiterplatten oder Platinen.

Die heutzutage üblichen und meistverbreiteten Verfahren in der Leiterplattentechnik stützen sich auf die Kupferätztechnik.

Ferner kennt man nach dem Stand der Technik das Platinenherstellungsverfahren der sogenannten "Drahtschreibung". Hierbei werden die Drähte aus elektrisch leitfähigem Material als verbindendes Medium zwischen den Anschlußpunkten der auf die Platine aufzubringenden elektronischen Bauelemente "drahtgeschrieben".

Aus der DE-PS 32 47 344 ist ein Verfahren zum Aufbringen von vorgeformten Leiterzügen auf eine Trägerplatte zum Herstellen von Leiterzugmustern bekannt, bei dem ein der Drahtschreibung vorausgehendender Verfahrensschritt der Fertigung einer mit metallischen Anschlußflächen versehenen Platte zu Grunde liegt.
Bei diesem Verfahren sind für die Leiterzüge entweder nur eine, oder maximal beide Oberflächen der die Schaltung tragenden Isolierstoffplatte als Verdrahtungsebenen verfügbar. was sich bei erhöhter Packungsdichte heutiger Platinen zum Nachteil auswirkt.

Aus der DE 25 08 545 ist ein Verfahren zum maschinellen Verlegen von Schaltdrähten bekannt, bei dem eine mehrlagige Anordnung von Verdrahtungsebenen in der Drahtschreibung dargestellt wird. Hier kommen ebenfalls vorgefertigte, Leiterzüge tragende Isolierstoffplatten mit den oben benannten Nachteil zum Einsatz. Die im Herstellungsprozeß anschließende Schichtung der einzelnen Trägerplatten zwingt zu einer Passervorrichtung, die die Universalität dieses Verfahrens einschränkt.

Ein Verfahren zum gegenseitigen Verbinden von elektronischen Mikrobausteinen ist ebenfalls aus der DE-OS 23 26 861 bekannt, das sich im Wesentlichen an die Vorgehensweise nach DE 32 47 344 anlehnt. Im Unterschied zu diesem werden hier Schaltungsträger für elektrische Bauelemente geschaffen, die gehäuselos sind oder einen speziellen, auf diese Platinenart angepaßte Gehäuseform besitzen.

In der US 4 627 162 wird ein Verfahren zum Herstellen einer drahtgeschriebenen Leiterplatte beschrieben, bei welchen die die Kontaktflächen zum Anbringen der elektronischen Bauelemente tragende Plattenoberfläche in einem getrennten Prozeßschritt mit der die Drähte des Leiterzugnetzwerkes tragenden Schicht in Verbindung gebracht wird. Hierbei entsteht wiederum der Nachteil einer aufwendigen, maßhaltigen Anpassung der verschieden vorgefertigten Schaltungsträgerschichten. Ebenso liegen hier die Leiterbahnzüge tragenden Ebenen entweder nur auf einer oder beiden Oberflächen der Leiterplatte und die zu erreichende Packungsdichte der elektronischen Bauelemente wird dadurch relativ gering gehalten.

Zum Stand der Technik gehören ebenso zwei verschiedene, diskrete Verbindungsarten, bekannt als "Multiwire"- und "Microwire"- Verbindungstechniken.

In der "Multiwire"-Technik werden die Leiterdrähte ein- oder beidseitig auf einer kleberbeschichteten Trägerplatte verlegt. Ein Nachteil dieses Verfahrens besteht in der elektrischen Ankontaktierung der auf die Platine aufzubringenden Bauelementanschlußflächen. Diese Ankontaktierung wird mittels Bohren der Trägerplatte und anschließender Verkupferung dieser und der an den Bohrungsrändern anliegenden Drahtenden erreicht. Hier muß zusätzlich zur Verfahrenstechnik der präzise durchzuführenden Drahtverlegung der aufwendige Prozeß einer Verkupferung zum Einsatz gelangen.

In der "Microwire"-Technik werden zur weiteren Steigerung der Packungsdichte der elektronischen Schaltung die Drahtdurchmesser verringert. Ein Nachteil dieses Verfahrens besteht wiederum in der gleichzeitigen Anwendung einer sehr genauen Drahtschreibung und der technisch aufwendigen Verkupferung von Bauelementanschlußflächen und Bohrungen.

Aufgabe der Erfindung ist die Schaffung eines Verfahrens und einer Vorrichtung zur Herstellung einer drahtgeschriebenen Leiterplatte oder Platine mit Hilfe einfacher und wirkungsvoller Mittel.

Gelöst wird die der Erfindung zugrundeliegende Aufgabe durch ein Fertigungsverfahren der im Patentanspruch 1 angegebenen Art, welches nach den Merkmalen der Ansprüche 2 bis 16 vorteilhaft weitergebildet wird.

Eine erfindungsgemäße Vorrichtung kennzeichnet sich durch die Merkmale des Patentanspruchs 17 mit der Weiterbildung der Vorrichtung entsprechend den Merkmalen des Anspruchs 18.

Insbesondere ist ein Verfahren zur Herstellung drahtgeschriebener Leiterplatten gekennzeichnet durch ein partielles Einfüllen einer härtbaren Isoliermasse in einer oben offenen Gießforrn, deren Größe der vorgegebenen Leiterplattenform entspricht, ein Positionieren von vorgefertigten, im wesentlichen gleich hohen, elektrisch leitfähigen Kontaktelementen, Aushärten der Isoliermasse, so daß die aus der gehärteten Masse hervorstehenden Kontaktelemente vorläufig fixiert werden, ein Verlegen von Drähten und Herstellung von elektrischen Verbindungen zwischen entsprechenden elektrisch leitfähigen Kontaktelementen nach einem vorgegebenen Schaltungsmuster, wobei sich die Drähte im Falle einer eigenen Drahtisolierung beliebig oft, jedoch begrenzt durch die Leiterplattenendhöhe und die verwendeten Drahtdurchmesser, kreuzen können und bei selbst nicht isolierten Drähten für eine Drahtkreuzung ein elektrisch nicht leitendes Material, insbesondere ein elektrisch nicht leitendes Folienstück zumindest im Bereich der Drahtkreuzung zwischengeordnet sein kann, folgendes Auffüllen der Gießform mit aushärtbarer Isoliermasse bis zur Endhöhe der Kontaktelemente und Aushärten der Masse zwecks Fixierung der Drähte und Kontaktelemente, wobei die Masse drucklos oder durch Vorsehen einer Abschlußplatte unter Druck eingebracht wird, und schließlich ein Entnehmen der ausgehärteten Leiterplatte aus der Gießform.

Ebenso können noch vor dem partiellen Einfüllen der härtbaren Isoliermasse die elektrisch leitfähigen Kontaktelemente positioniert werden. Es kann vorgesehen sein, daß vor einem Positionieren der Kontaktelemente zwecks vorläufiger Fixierung derselben eine Haft- oder Klebeschicht in die Gießform ein- oder aufgebracht, insbesondere aufgesprüht wird, wobei auf der Haft- oder Klebeschicht zusätzlich eine Verdrahtungsebene ausgebildet sein kann. Ein Fixieren positionierter Kontaktelemente kann auch durch Magnetschluß, beispielsweise durch magnetisch auf der Unterlage haftende Elemente, erfolgen.

Auch kann zwecks Erhöhung der Packungsdichte der Leiterplatte vorgesehen sein, die Leiterplatte aus mehreren in Isolierstoff eingegossenen Verdrahtungsebenen auszubilden, wobei die Anzahl der Verdrahtungsebenen durch die Leiterplattenendhöhe und die verwendeten Drahtdurchmesser begrenzt wird.

Eine besonders gute Fixierung von Drähten ergibt sich, wenn vor der Drahtverlegung bzw. Drahtverschreibung ein Klebefilm auf der Oberfläche der Isolierschicht aufgesprüht wird.

Insbesondere kann nach einem Verlegen der Drähte einer Verdrahtungsebene in das Trägermaterial eine vorgefertigte, die durchgehenden Aussparungen für die Kontaktelemente enthaltende Materialschicht, vorzugsweise aus Metall, zwecks Steifigkeitserhöhung, elektromagnetischer Abschirmung, Kühlung und/ oder zwecks Stromversorgung durch nachträgliches Verbinden mit den Kontaktelementen, eingegossen bzw. aufgesetzt oder aufgeklebt werden, wobei die Aussparungen vorzugsweise durch Spanen oder durch Laser mit Übermaß vorher aus der Materialschicht herausgearbeitet werden.

Es kann vorgesehen sein, zumindest eine vorgefertigte, aus elektrisch isolierender Masse bestehende Platte, die durchgehende Aussparungen aufweist, welche in Form und Lage der in der Leiterplatte zur Verwendung kommenden Kontaktelemente entsprechen, vor der Drahtverschreibung in die Platine einzubringen, wobei diese Isolierstoffplatte zusätzlich eine Fixierung der Kontaktelemente bewirkt.

Das Positionieren der Kontaktelemente erfolgt bevorzugt durch Setzen der Kontaktelemente über eine mit einem elektronischen Rechner verbundene 3- oder Mehr-Koordinatensetzmaschine

Vor einer Endmontage der Platine werden bevorzugt die Leiterplatten-Oberseite und / oder die Leiterplatten-Unterseite plan bearbeitet, insbesondere abgeschliffen, um die gewünschte exakte Endhöhe der Platine einzurichten und die Anschlußflächen der elektrisch leitfähigen Kontaktelemente zu optimieren bzw. zu säubern.

Die verwendeten elektrischen Kontaktelemente einer erfindungsgemäß gefertigten Leiterplatte weisen an mindestens einer Leiterplattenoberfläche eine zur Montage der verschiedenen Bauelemente notwendige, genau angepaßte Form auf, und die Höhe der Kontaktelemente entspricht bei beidseitig aus der Leiterplattenoberfläche austretenden Kontaktelemente vorzugsweise der Leiterplattenendhöhe oder bei nur einseitig aus der Leiterplatte austretenden Kontaktelementen einer geringeren Höhe als der Leiterplattenendhöhe.

Da die an den Bauelementanschlüssen in ihrem Abmaß orientierten Kontaktelemente bei kleinen Bauelementgrößen schwierig an den zur Drahtschreibung verwendeten Draht anzukontaktieren sind, können die hier zum Einsatz gelangenden Kontaktelemente eine vergrößerte Drahtanschlußfläche aufweisen oder ebenso im Falle kleiner Bauelementgrößen in vorteilhafter zu verarbeitenden Kontaktelementmodulen vorgefertigt werden.

Auch kann eine erfindungsgemäß gefertigte Leiterplatte bei entsprechender Ausbildung der Gießform in eine dreidimensionale, nicht ebene Form gebracht werden.

Während eines zwischen zugeordneten Kontaktelementen mit Hilfe der Drähte vollzogenen Verbindungsaufbaus kann gleichzeitig die elektrische Leitfähigkeit der Leitungsverbindung kontrolliert werden.

Werden an Stelle der in die Leiterplatte in Isolierstoff eingegossenen Kontaktelemente die Anschlußdrähte von THD-Bauelementen bzw. die Anschlußflächen von SMD-Bauelementen verwendet, können die Kontaktelemente entfallen.

Eine Vorrichtung zur Durchführung des Verfahrens zur Herstellung drahtgeschriebener Leiterplatten kennzeichnet sich vor allem durch eine mit einem elektronischen Rechner verbundene 3- oder Mehr-Koordinaten-Setzmaschine zum Setzen der Kontaktelemente in einem gewünschten Schaltungsmuster, wobei die Arbeitsfläche der Setzmaschine den Boden der oben offenen Gießform bilden kann und der Umfangsrahmen der Gießform durch Randklötze gebildet sein kann, welche insbesondere auf der Arbeitsfläche der Setzmaschine verschiebbar oder versetzbar sind, eventuell durch eine hydraulische Hilfskraft.

Die Setzmaschine weist bevorzugt einen 3-oder mehrdimensional verstellbaren Setzarm mit einer Positionierungsklammer zum Positionieren der elektrisch leitenden Kontakelemente und/oder mit einer Führungsklammer zur Drahtverlegung bzw. Drahtverschreibung auf, wobei vorzugsweise nach einem Positionieren die Positionierungsklammer gegen die Führungsklammer auf dem Setzarm austauschbar ist.

Eine erfindungsgemäß gefertigte Leiterplatte kennzeichnet sich also vor allen Dingen durch eine erste Leiterplattenschicht aus ausgehärteter Isolierstoffmasse mit oberseitiger Drahtverschreibung oder beispielsweise auch aus einer vorgefertigten, zur Aufname der Kontaktelemente mit Aussparungen versehenen Isolierstoffplatte mit oberseitiger Drahtverschreibung und eine zweite, die Drahtverschreibung einhüllende und fixierende Leiterplattenschicht aus ausgehärteter Isolierstoffmasse, wobei die Leiterplattenschichten elektrisch leitende, positionierte Kontaktelemente, oben und / oder unten bündig die Leiterplattenschichten durchdringend, fixieren. Die Ober- und / oder die Unterseite der Leiterplatte sind plangeschliffen, wobei die Leiterplatte aus mehr als einer in Isolierstoff eingegossenen Verdrahtungsebene ausgebildet sein kann. Die Kontaktelemente sind zweckmäßigerweise Metallhülsen und / oder Metallquader aus elektrisch leitenden Material, insbesondere Elektrokupferelemente.

Die Erfindung zielt mithin darauf ab, sämtliche Leitungen deutlich innerhalb der Platine oder beispielsweise bei hoher Packungsdichte auch sehr knapp unter der Oberfläche zu verlegen. Durchkontaktierungen und Bohrungen bei der Fertigung, mit Ausnahme der mechanischen Befestigungen von speziellen Bauelementen, entfallen.
Ein technologischer Unterschied zu den oben genannten bekannten Verfahren besteht darin, daß die vorgefertigten, elektrischen Kontaktelemente auf der fertiggestellten Platine für die Befestigung der elektronischen Bauelemente definierte Oberflächen ausbilden, gleichzeitig einen Knotenpunkt im Verdrahtungsnetzwerk bilden und zudem, bei gleicher Höhe, die der Platinenendhöhe entspricht, eine Durchkontaktierung von Platinenoberseite zu Platienunterseite darstellen, und diese zur Ausbildung des Verdrahtungsnetzwerkes innerhalb der Platine durch Drahtverschreibung ankontaktiert werden.

Für Bauelemente in Steckgehäuseform sind Metallröhrchen mit entsprechendem Innen und Außendurchmesser vorgesehen.
Bei anderen Elementen, wie z.B. SMD-Widerständen, SMD-ICs, etc., kommen Metallquader mit entsprechenden Oberflächenabmaßen zur Verwendung.

Die Vorteile der Erfindung im Vergleich zu herkömmlichen durch Drahtschreibungsverfahren hergestellte Platinen lassen sich u.a. in den folgenden Punkten aufführen:

Da keine Drähte auf den Oberflächen der Platinen aufgebracht sind steht somit für die Bestückung der elektronischen Bauelemente eine größtmögliche Platinenoberfläche zur Verfügung.

Die Drahtverschreibung der innerhalb der Platine eingebetteten Drähte darf in einer geringen Präzision erfolgen, da ein nachträgliches Anbohren zum Ankontaktieren der Drähte entfällt.

Der Vorgang des Bohrens von Anschlußöffnugen für THD-Bauelemente und Ankontaktierungen verlegter Drähte entfällt vollständig.

An den längs den Kontaktelementen innerhalb der Platine liegenden Umfangsflächen dieser wird ein in Vergleich zu nur auf den Platinenoberflächen liegenden Kontaktelementen großer Anschlußbereich für die Drähte ausgebildet, was höhere Packungsdichten ermöglicht.

Zusätzliche Metallisierungen der Platinenoberfläche an Anschlußpunkten der elektronischen Bauelemente sind nicht mehr notwendig. Somit entfällt der Einsatz einer Galvanisieranlage. was umweltfreundlich ist.

Die im Sinne der Erfindung gefertigte Leiterplatte unterscheidet sich im weiteren Gebrauch nicht von einer in einem herkömmlichen Verfahren hergestellten Leiterplatte.

Maschinelle Bestückungsverfahren und Aufdrucktechniken für Bauelementbezeichnungen können weiterhin zum Einsatz gelangen.

Auch ist die Herstellung dreidimensionaler, nicht ebener Leiterplatten möglich.

Die Fixierung der elektrisch leitenden Kontaktelemente kann nicht nur durch Haftvermittlerauftrag, sondern auch z.B. durch Magnete erfolgen.

Gegebenenfalls können die Bauelementanschlüsse ebenfalls innerhalb der Platine liegen, wobei dann einzelne Kontaktelemente entfallen.

Die Erfindung wird nachfolgend anhand von Ausführungsbeispielen unter Bezugnahme auf die beigefügten Zeichnungen näher beschrieben; es zeigen:
- Fig. 1: eine fertiggestellte Leiterplatte oder Platine ähnlich Fig. 6, jedoch mit nur einer inneren Verdrahtungsebene,
- Fig. 2: die in Fig.1, Fig.6 oder Fig.7 veranschaulichte Leiterplatte in einem Verfahrensschritt ihrer Herstellung unter Darstellung einer die positionierten, elektrisch leitenden Kontaktelemente, nach Fig.8. fixierenden Isolierstoffschicht,
- Fig. 3: die Anordnung nach Fig.2 in einem nachfolgenden Herstellungsschritt der Leiterplatte mit zusätzlicher Darstellung von Drahtverbindungen zwischen den elektrisch leitenden Kontaktelementen,
- Fig. 4: die Anordnung nach Fig.3 mit zusätzlicher Drahtüberkreuzung in einer Verdrahtungsebene,
- Fig. 5: die Anordnung nach Fig.3 während der Ausbildung einer nächsten Verdrahtungsebene,
- Fig. 6: eine nach dem erfindungsgemäßen Verfahren hergestellte Leiterplatte oder Platine in einer schematisch perspektivischen Darstellung mit elektrisch leitenden Kontaktelementen nach Fig. 8, mit zwei inneren Verdrahtungsebenen,
- Fig. 7: eine fertiggestellte Leiterplatte ähnlich Fig. 1 mit zusätzlich eingebrachter Metalleinlage zur Verstärkung, Kühlung, für eine elektromagnetische Abschirmung und/oder für eine Stromversorgung durch nachträgliches Verbinden mit den elektrisch leitenden Kontaktelementen,
- Fig.8: Beispiele zweier nach dem erfindungsgemäßen Verfahren hergestellter Leiterplatten ohne (Fig. 8a) und mit (Fig.8b) vorgefertigter Isolierstoffplatte in Schnittdarstellung.
- Fig. 9: Beispiele einzelner elektrisch leitender Kontaktelemente in Form von Metallhülsen und Metallquadern in verschiedenen Höhen und verschiedenen Querschnittsformen,
- Fig. 10: Beispiele von Kontaktelementen die in vorgefertigter Modulbauweise an Stelle einzeln zu setzender elektrisch leitender Kontaktelemente zum Einsatz gelangen können,
- Fig. 11: eine Führungsklammer eines Setzsarmes einer mit einem elektronischen Rechner verbundenen 3-oder Mehr-Koordinaten-Setzmaschine in einer drahtverschieblichen Stellung während einer Drahtverlegung (links) und einer Haltestellung des Drahtes während einer elektrischen Leitungsanbindung an ein zugeodnetes Kontaktelement (rechts), und
- Fig. 12: eine fertiggestellte Leiterplatte nach Fig. 6 mit zusätzlicher Darstellung oberseitig angebrachter elektronischer Bauelemente.

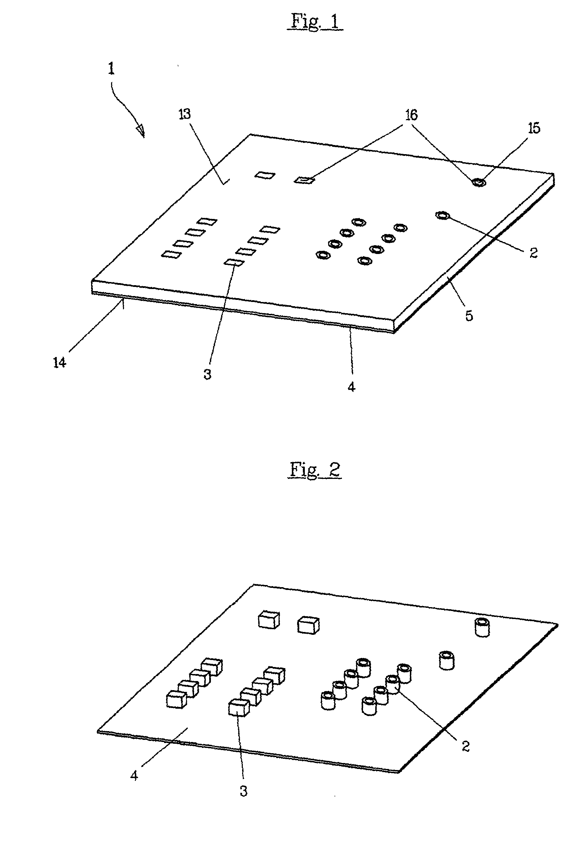

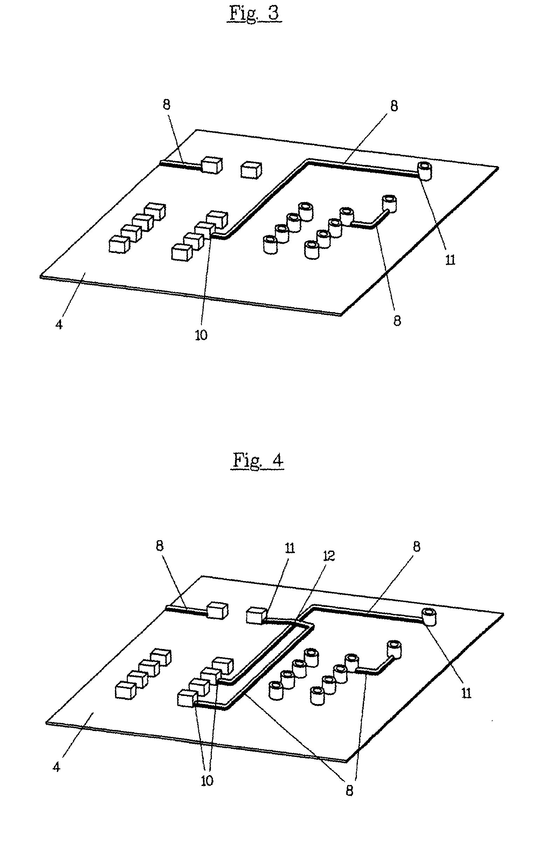

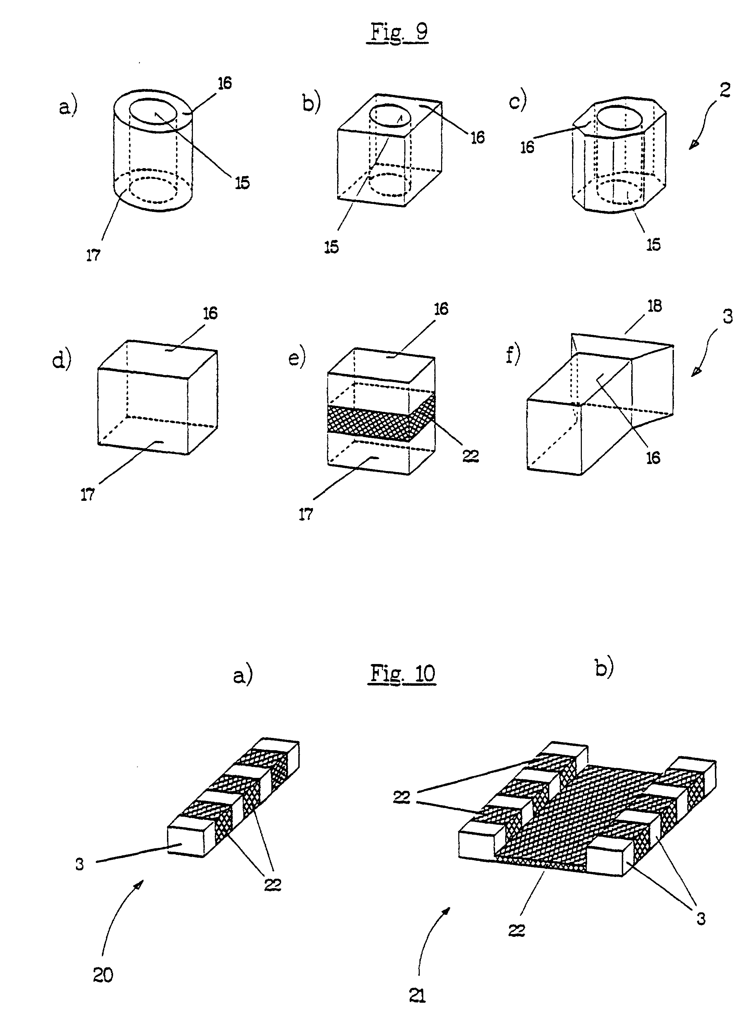

Um eine drahtgeschriebene Leiterplatte oder Platine 1 gemäß Fig.1 unter Verwendung von elektrisch leitenden Kontaktelementen 2,3 nach Fig. 9 in Verbundweise herzustellen, sind folgende sechs Verfahrensschritte grundsätzlich erforderlich:
- Einfüllen einer aushärtbaren Isoliermasse in die Gießform zwecks Ausbildung einer ersten elektrisch isolierenden Leiterplattenschicht 4 beispielsweise gemäß Fig. 2.
- Positionieren von im wesentlichen gleich hohen, elektrisch leitfähigen, vorgefertigten Kontaktelementen 2,3 beispielsweise gemäß Fig. 2 in einer (nicht veranschaulichten) oben offenen Gießform mit einem Umfangsrahmen entsprechend einer vorgegebenen Form einer zu fertigenden Leiterplatte 1, wobei das Positionieren der Kontaktelemente 2,3 vorzugsweise über eine mit einem elektronischen Rechner verbundene (nicht veranschaulichte) 3-oder Mehr-Koordinaten-Setzmaschine erfolgt.
- Aushärtung der Isoliermasse zwecks Fixierung der aus der ersten Leiterplattenschicht 4 beispielsweise gemäß Fig. 2 hervorstehenden, elektrisch leitenden Kontaktelemente.
- Verlegen der Drähte 8 gemäß Fig. 3 zwischen zugeordneten Kontaktelementen 2,3 auf der ersten Leiterplattenschicht 4 mit Herstellung einer elektrischen Leitungsverbindung 10,11 zwischen den zugeordneten Kontaktelementen entsprechend dem vorgegebenen Schaltungsmuster.
- Weiteres Füllen der Gießform mit aushärtbarer Isoliermasse bis zur gewünschten Leiterplattenendhöhe im Bereich der Endhöhe der elektrischen Kontaktelemente zwecks Ausbildung einer zweiten, elektrisch isolierenden Leiterplattenschicht 5 gemäß Fig. 1 und Fixierung der verlegten Drähte 8 sowie weiterer Fixierung der elektrischen Kontaktelemente.
- Entfernen der ausgehärteten Leiterplatte 1 gemäß Fig. 1 aus der Gießform.

Eine erfindungsgemäße Herstellung einer Leiterplatte 1 läßt sich beispielhaft in mehreren Arbeitsschritten erklären:

Design und Entwurf der elektronischen Schaltung erfolgen auf einer CAD-Station.

Partielles Einfüllen einer aushärtbaren Isoliermasse in einer oben offenen Gießform zur Ausbildung einer Isolierschicht 4 gemäß Fig 1. Bauelementdaten, Abstände der Anschlußpins von THD-Bauelementen, SMD-Anschlußflächen 16,17 gemäß Fig. 9 usw., gehen von einem Rechner an eine numerisch gesteuerte Setzmaschine, die die entsprechenden, vorgefertigten, elektrisch leitenden Kontaktelemente 2,3 in die mit einer ersten Leiterplattenschicht 4 gefüllte Gießform maßgerecht einsetzt. Zur Fixierung der Kontaktelemente erfolgt eine Aushärtung der Isolierschicht 4 gemäß Fig. 2.

Alternativ wäre es möglich, als ersten Arbeitsschritt zur vorläufigen Fixierung der Kontaktelemente einen Klebefilm in die Gießform einzubringen (nicht gezeigt), als zweiten Arbeitsschritt die elektrisch leitfähigen Kontaktelemente maßgerecht auf die Grundplatte der Gießform aufzusetzen und als dritten Arbeitsschritt die erste Isolierstoffschicht 4 gemäß Fig. 1 partiell einzufüllen und diese zwecks Fixierung der Kontaktelemente auszuhärten. Die Klebeschicht kann ebenfalls mit einer Verdrahtungsebene ausgestattet sein.

Darüber hinaus ist es zweckmäßig, nach dem Aushärten der ersten isolierenden, die elektrischen Kontaktelemente fixierenden Leiterplattenschicht 4 einen elektrisch nicht leitenden Klebefilm auf dieser Schicht 4 zur Justierung des zu verlegenden Drahtes aufzusprühen.

Zur eigentlichen Drahtverlegung bzw. Drahtverschreibung findet ein vorzugsweise isolierter (z.B. mit einer Lackschicht versehener) Draht 8, vorzugsweise Elektrokupferdraht, Verwendung.

Der Drahtanfang wird beispielsweise in eine schematisch in Fig. 11 gezeigte Führungsklammer 9 eingeführt und in einer Haltestellung der Führungsklammer beispielsweise gemäß Fig. 11, rechts, gehalten, sowie an den anzuschließenden elektrisch leitenden Kontaktelementen 2,3 angelegt und anschließend elektrisch leitend verbunden, insbesondere verschweißt, verlötet oder leitgeklebt.

Ist ein Leitungsanschluß 10,11 mit einem Kontaktelement 2 bzw. 3 hergestellt, wird die Führungsklammer 9 in eine drahtverschiebliche Verlegestellung, verdeutlicht in Fig. 11, links, gelöst und dann der Draht mit Hilfe der Führungsklammer 9 auf der vom elektronischen Rechner vorgegebenen Bahn durch Verschieben der Führungsklammer längs der Bahn verlegt (wobei Kreuzungsstellen von Drähten 12 gemäß Fig. 4 vorgesehen sein können und bei kreuzungsfreien Drahtverlauf auch ein nicht isolierter Draht verwendet werden kann).

Ist ein Draht 8 bis zu seinem Drahtende verlegt, wird das mittels der Führungsklammer 9 in der Haltestellung bespielsweise gemäß Fig. 11, rechts, festgehaltene Drahtende auch dort an das anzuschließende, elektrisch leitende Kontaktelement angelegt und elektrisch leitend verbunden, insbesondere verschweißt, verlötet oder leitgeklebt. Während des Verbindungsaufbaus kann gleichzeitig auch die elektrische Leitfähigkeit der Leitungsverbindung kontrolliert werden.

Der verbleibende Restraum zwischen der ersten Isolierstoffschicht 4 und der vollen Stärke der Platine kann nun durch weiteres Auffüllen der Gießform mit aushärtbarer Isoliermasse bis zur Endhöhe der Kontaktelemente entweder drucklos oder durch Vorsehen einer Abschlußplatte unter Druck ausgefüllt werden. Das nachfolgende Aushärten der so entstandenen, in Isolierstoff eingegossenen Verdrahtungsebene 5 dient gleichzeitig auch zur weiteren Fixierung der Kontaktelemente und zur Fixierung der innerhalb der Platine liegenden Drähte.

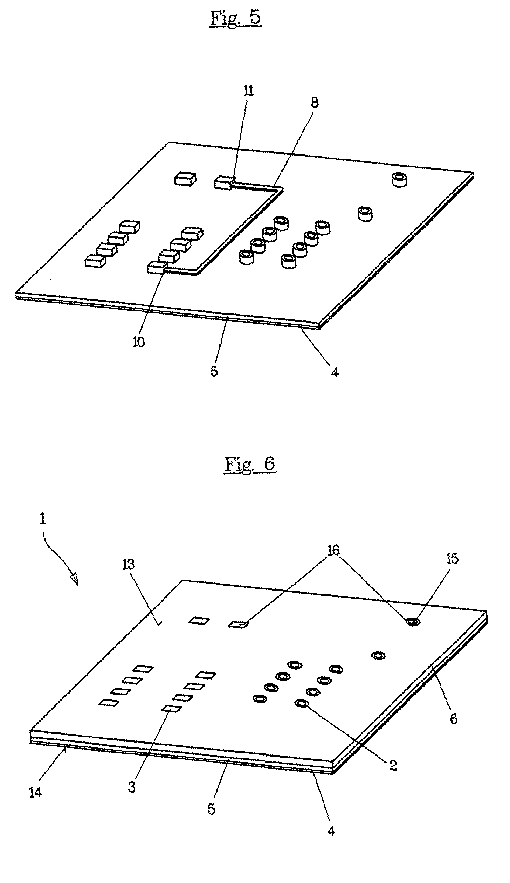

Bei Leiterplatten mit hoher Packungsdichte sind die Schritte des Aufbringens des Klebefilms. der Drahtbeschreibung, Anschlußherstellung und Auffüllung mit aushärtbarer Isoliermasse des öfteren möglich, so daß sich eine Mehrfachschichtung der Verdrahtungsebenen beispielsweise gezeigt in Fig. 6 mit erster Verdrahtungsebene 5 und zweiter Verdrahtungsebene 6 ergibt. Eine Veranschaulichung einer auf eine in Isolierstoff eingegossenen und ausgehärteten Verdrahtungsebene 5 beispielsweise zweiten Drahtverschreibung zeigt Fig. 5.

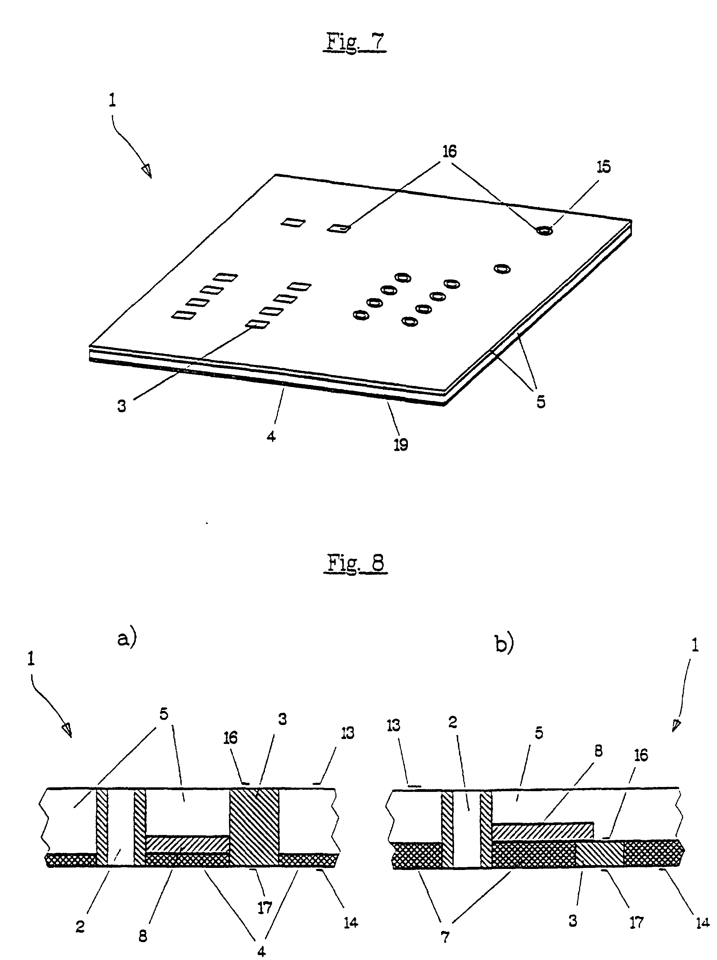

Zusätzlich kann nach einem Verlegen der Drähte einer Verdrahtungsebene 5 oder 6 in die Isolierstoffmasse eine vorgefertigte, die durchgehenden Aussparungen für die Kontaktelemente enthaltene Materialschicht 19 beispielsweise gemäß Fig. 7 zwecks Steifigkeitserhöhung, elektromagnetischer Abschirmung, Kühlung und/ oder zwecks Stromversorgung durch nachträgliches Verbinden mit den Kontaktelementen, eingegossen bzw. aufgesetzt oder aufgeklebt werden.

Bei Verwendung einer mit Aussparungen für die elektrischen Kontaktelemente 2,3 versehenen, vorgefertigten Isolierstoffplatte 7 beispielsweise gemäß Fig. 8b kann diese vorzugsweise die erste Isolierstoffschicht 4 zur Fixierung der Kontakelemente ersetzen, außerdem eine Leiterplattenoberfläche 14 ausbilden und mit Kontaktelementen, die Anschlußflächen auf entweder nur einer oder beiden Leiterplattenoberflächen aufweisen, bestückt werden. In weiteren Verfahrensschritten können dann nach dem erfindungsgemäßen Verfahren eine oder mehrere Verdrahtungsebenen 5,6 auf dieser bis zur Leiterplattenendhöhe aufgebracht werden.

Die zur Verwendung kommenden, elektrisch leitenden Kontaktelemente sollen aus leitfähigem Material bestehen, vorzugsweise Elektrokupfer, sind in ihrer Höhe der zu fertigenden Leiterplatte 1 oder einer vorgefertigten Isolierstoffplatte 7 angepaßt und besitzen in ihrem, vorzugsweise an der aus der Leiterplatte austretenden Fläche, gefertigten Querschnitt eine zur Anschlußfläche der elektronischen Bauelemente definierte Form.

Sie können Metallhülsen 2 gemäß Fig. 9a bis 9c in verschiedenen Ausführungsformen sein, die definierte Lötanschlußflächen 16,17 für eine Bauelementmontage und definierte Öffnungen 15 zur Aufnahme der Bauelementpins von THD-Bauelementen besitzen. Sie können Metallquader 3 gemäß Fig. 9d bis 9f in verschieden Ausführungsformen sein, die definierte Lötanschlußflächen 16,17 zur Kontaktierung von SMD-Bauelementpins besitzen. mit Isolierstoff 22 versehen sein, und beispielsweise zur besseren Drahtkontaktierung bei Fine Pitch SMD-Bauelementen eine vergrößerte Anschlußfläche 18 gemäß Fig. 9f aufweisen.

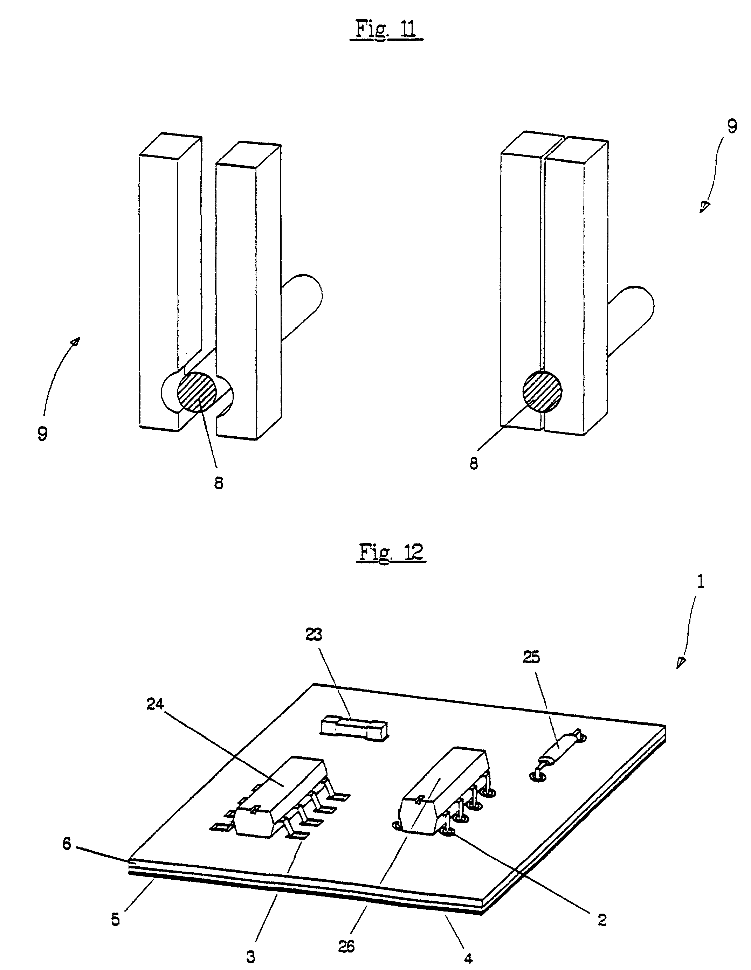

Die elektrischen Kontaktelemente können, um den Verfahrensprozess des Setzens mittels einer numerisch kontrollierten Setzmaschine zu beschleunigen, aus vorgefertigten Modulen 20,21 beispielsweise gezeigt in Fig. 10a oder 10b bestehen, die aus den zuvorgenannten, elektrisch leitenden Kontaktelementen 2 oder 3 mit zwischengelagerten, aus Isolierstoffmasse bestehenden Abstandsräumen in ihrer Form gehalten werden, und somit an standardisierte, elektronische Bauelemente und deren Anschlußpins bzw. Anschlußflächen in maßhaltiger Form angepaßt sind.

Nach Aushärtung der in Isolierstoff eingegossenen letzten Verdrahtungsebene 5 in Fig. 1 oder Fig. 7 oder Verdrahtungsebene 6 nach Fig. 6 wird diese aus der Gießform genommen und vorzugsweise die Oberseite 13 und die Unterseite 14 der Leiterplatte plan geschliffen um eine maßhaltige Anpassung an die später zu bestückenden, elektronischen oder mechanischen Bauelemente zu schaffen.

Im weiteren Gebrauch unterscheidet sich die im Sinne der Erfindung gefertigte Leiterplatte nicht von einer in einem herkömmlichen Verfahren hergestellten Leiterplatte, jedoch ist es möglich, das erfindungsgemäße Verfahren auch auf 3-dimensionale, nicht ebene Schaltungsträger anzuwenden und somit eine andersgeartete Gebrauchsform der Leiterplatte in einfacher Weise herzustellen.

Es sei noch angemerkt, daß in den Unteransprüchen enthaltene, selbständig schutzfähige Merkmale trotz der vorgenommenen formalen Rückbeziehung auf den Hauptanspruch entsprechenden eigenständigen Schutz haben sollen. Im übrigen fallen sämtliche in den gesamten Anmeldungsunterlagen enthaltenen erfinderischen Merkmale in den Schutzumfang der Erfindung.

## Patentansprüche

1. Verfahren zur Herstellung von drahtgeschriebenen Leiterplatten (1), **gekennzeichnet durch**
- partielles Einfüllen einer härtbaren Isoliermasse (4) in eine oben offenen Gießform, deren Größe der vorgegebenen Leiterplattenform entspricht,
- Positionieren von vorgefertigten, im wesentlichen gleich hohen, elektrisch leitenden Kontaktelementen (2,3) zur Bauelementfixierung,
- Aushärten der Isoliermasse (4), so daß die aus der gehärteten Masse hervorstehenden Kontaktelemente (2,3) vorläufig fixiert werden,
- Verlegen von Drähten (8) und Herstellung von elektrischen Verbindungen (10,11) zwischen entsprechenden Kontaktelementen(2,3), wobei sich die Drähte (8) im Falle einer eigenen Drahtisolierung beliebig oft, jedoch begrenzt **durch** die Leiterplattenendhöhe und die verwendeten Drahtdurchmesser, kreuzen können und bei selbst nicht isolierten Drähten für eine Drahtkreuzung (12) ein elektrisch nicht leitendes Material, insbesondere ein elektrisch nicht leitendes Folienstück zumindest im Bereich der Drahtkreuzung (12) zwischengeordnet sein kann,
- Auffüllen der Gießform mit aushärtbarer Isoliermasse (5) bis zur Endhöhe der Kontakelemente (2,3) und Aushärten der Masse (Fixierung der Drähte (8) und der Kontaktelemente (2,3)), wobei die Masse
- drucklos oder
- **durch** Vorsehen einer Abschlußplatte unter Druck eingebracht wird,
- Herausnehmen der ausgehärteten Leiterplatte (1) aus der Gießform.

2. Verfahren nach Anspruch 1
**dadurch gekennzeichnet,**
**daß** vor dem partiellen Einfüllen der härtbaren Isoliermasse (4) die elektrisch leitenden Kontaktelemente (2,3) positioniert und ggf. fixiert werden.

3. Verfahren nach Anspruch 2
**dadurch gekennzeichnet,**
**daß** vor einem Fixieren der Kontaktelemente (2,3) zwecks vorläufiger Fixierung derselben eine Haft- oder Klebeschicht in die Gießform ein-/aufgebracht, insbesondere aufgesprüht, wird, wobei auf der Haft- oder Klebeschicht eine Verdrahtungsebene ausgebildet sein kann.

4. Verfahren nach einem der Ansprüche 2
**dadurch gekennzeichnet,**
**daß** die Kontaktelemente (2,3) mittels Magnete fixiert werden.

5. Verfahren nach einem der Ansprüche 1 bis 4
**dadurch gekennzeichnet,**
**daß** die Leiterplatte aus mehr als einer in Isolierstoff eingegossenen Verdrahtungsebene (5,6), deren Anzahl jedoch begrenzt durch die Leiterplattenendhöhe und die verwendeten Drahtdurchmesser ist, ausgebildet wird.

6. Verfahren nach einem der Ansprüche 1 bis 5
**dadurch gekennzeichnet,**
**daß** das Positionieren der Kontaktelemente (2,3) durch Setzen der Kontaktelemente über eine mit einem elektronischen Rechner verbundene 3-oder Mehr-Koordinaten-Setzmaschine erfolgt.

7. Verfahren nach einem der Ansprüche 1 bis 6
**dadurch gekennzeichnet,**
**daß** nach dem Aushärten der ersten Isolierschicht (4) bzw. einer in Isolierstoff eingegossenen Verdrahtungsebene (5) und vor der Drahtverlegung bzw. Drahtverschreibung ein Klebefilm zwecks Justierung des Drahtes (8) auf dieser aufgesprüht wird.

8. Verfahren nach einem der Ansprüche 1 bis 7
**dadurch gekennzeichnet,**
**daß** nach einem Verlegen der Drähte (8) einer Verdrahtungsebene in das Trägermaterial (5,6) eine vorgefertigte, die durchgehenden Aussparungen für die Kontaktelemente (2,3) enthaltende Materialschicht (19), vorzugsweise aus Metall, zwecks Steifigkeitserhöhung, elektromagnetischer Abschirmung, Kühlung und / oder zwecks Stromversorgung durch nachträgliches Verbinden mit den Kontaktelementen (2,3), eingegossen bzw. aufgesetzt oder aufgeklebt wird, wobei die Aussparungen vorzugsweise durch Spanen oder durch Laser mit Übermaß vorher aus der Materialschicht herausgearbeitet werden.

9. Verfahren nach einem der Ansprüche 1 bis 8
**dadurch gekennzeichnet,**
**daß** die Leiterplatten-Oberseite (13) und / oder die Leiterplatten-Unterseite (14) plan bearbeitet, insbesondere abgeschliffen, wird.

10. Verfahren nach einem der Ansprüche 1 bis 9
**dadurch gekennzeichnet,**
**daß** die an den Leiterplattenoberflächen (13,14) austretenden Kontaktelement-Oberflächen (16,17) in einer zur Montage der verschiedenen Bauelemente notwendigen Form ausgebildet werden.

11. Verfahren nach einem der Ansprüche 1 bis 10
**dadurch gekennzeichnet,**
**daß** eine vorgefertigte, mit Aussparungen für die Kontaktelemente (2,3) versehene Isolierstoffplatte (7) als Leiterplattenschicht zur Verwendung gelangt.

12. Verfahren nach einem der Ansprüche 1 bis 11
**dadurch gekennzeichnet,**
**daß** die Kontaktelemente dergestalt zugeordnet werden, daß die Höhe der bei beidseitig aus der Leiterplattenoberfläche (13,14) austretenden Kontaktelemente (2,3) der Leiterplattenendhöhe entspricht oder bei nur einseitig aus der Leiterplattenoberfläche austretenden Kontaktelementen einer geringeren als die der Leiterplattenendhöhe entspricht.

13. Verfahren nach einem der Ansprüche 1 bis 12
**dadurch gekennzeichnet,**
**daß** die Kontaktelemente (2,3) entweder bei kleinen Abmessungen mit einer vergrößerten Anschlußfläche (18) für die Drähte (8) ausgebildet oder bereits im voraus in Kontaktelementmodulen (20,21) vorgefertigt werden.

14. Verfahren nach einem der Ansprüche 1 bis 13
**dadurch gekennzeichnet,**
**daß** durch eine entsprechende Ausbildung der Gießform auch dreidimensionale, nicht ebene Leiterplatten hergestellt werden.

15. Verfahren nach einem der Ansprüche 1 bis 14
**dadurch gekennzeichnet,**
**daß** während eines zwischen zugeordneten Kontaktelementen (2,3) mit Hilfe der Drähte (8) vollzogenen Verbindungsaufbaus gleichzeitig die elektrische Leitfähigkeit der Leitungsverbindung kontrolliert wird.

16. Verfahren nach einem der Ansprüche 1 bis 15
**dadurch gekennzeichnet,**
**daß** die Anschlußdrähte der THD-Bauelemente (25,26) bzw. die Anschlußflächen der SMD-Bauelemente (23,24) als Kontaktelemente ausgebildet werden.

17. Vorrichtung zur Durchführung des Verfahrens zur Herstellung drahtgeschriebener Leiterplatten nach einem der Ansprüche 1 bis 16
**dadurch gekennzeichnet,**
**daß** eine mit einem elektronischen Rechner verbundene 3-oder Mehr-Koordinaten-Setzmaschine zum Positionieren der Kontaktelemente (2,3) in einem gewünschtem Schaltungsmuster vorgesehen ist, wobei die Arbeitsfläche der Setzmaschine den Boden der oben offenen Gießform bildet und der Umfangsrahmen der Gießform durch Randklötze gebildet sein kann, welche insbesondere auf der Arbeitsfläche der Setzmaschine verschiebbar oder versetzbar sein können.

18. Vorrichtung nach Anspruch 17
**dadurch gekennzeichnet,**
**daß** die 3-oder Mehr-Koordinaten-Setzmaschine einen Setzarm mit einer Positionierungsklammer zum Positionieren der Kontaktelemente (2,3) und / oder mit einer Führungsklammer (9) zur Drahtverlegung bzw. Drahtverschreibung aufweist, wobei vorzugsweise nach einem Positionieren die Positionierungsklammer gegen die Führungsklammer (9) auf dem Setzarm austauschbar ist.

## Claims

1. Process for manufacturing wire-written printed circuit boards (1),
**characterized by**
- the partial filling of a curable insulating compound (4) into a casting mold, which is open at the top and whose size corresponds to the size of the predetermined shape of the printed circuit board,
- positioning of prefabricated electrically conductive contact elements (2, 3), essentially of equal height, for fixing the components,
- curing of the insulating compound (4), so that the said contact elements (2, 3) projecting from the cured compound are temporarily fixed,
- laying of wires (8) and establishing of electronic connections (10, 11) between corresponding contact elements (2, 3), wherein said wires (8) may cross one another as often as desired, if they have a wire insulation of their own, but the frequency of crossings is limited by the final height of the printed circuit board and the wire diameter used, and if the wires are not insulated themselves, an electrically nonconductive material, especially a piece of electrically nonconductive foil, may be interposed for a wire crossing at least in the area of said wire crossing (12).
- filling of the casting mold with curable insulating compound (5) up to the final height of the contact elements (2, 3) and curing of the compound (fixation of the wires (8) and of said contact elements (2, 3)), wherein the compound may be introduced
- in an unpressurized manner or
- under pressure if a closing plate is provided,
- removal of the cured printed circuit board (1) from the casting mold.

2. Process in accordance with claim 1,
**characterized in that**
said electrically conductive contact elements (2, 3) are positioned and optionally fixed before said curable insulating compound (4) is filled in partially.

3. Process in accordance with claim 2,
**characterized in that**
an adhesive layer is introduced into/applied to, especially sprayed into the casting mold before the fixation of said contact elements (2, 3) for the purpose of temporary fixation of said contact elements, and a wiring plane may be formed on the adhesive layer.

4. Process in accordance with one of the claims 1 - 3,
**characterized in that**
the contact elements (2, 3) are fixed by means of magnets.

5. Process in accordance with one of the claims 1 - 4,
**characterized in that**
the printed circuit board is formed by more than one wiring plane (5, 6), which is integrally cast in insulating material, but the number of these wiring planes is limited by the final height of the printed circuit board and the wire diameter used.

6. Process in accordance with one of the claims 1 - 5,
**characterized in that**
the contact elements (2, 3) are positioned by setting said contact elements by means of a three-coordinate or more-than-three-coordinate setting machine connected to an electronic computer.

7. Process in accordance with one of the claims 1 - 6,
**characterized in that**
after the curing of the first insulating layer (4) of . a wiring plane (5) cast integrally in insulating material and before the laying of the wire or wire-writing, an adhesive film is sprayed on to adjust the wire (8) thereon.

8. Process in accordance with one of the claims 1 - 7,
**characterized in that**
after laying the wires (8) of a wiring plane, a prefabricated material layer (19), which contains the through holes for the contact elements (2, 3) and preferably consists of metal, is cast integrally in or attached or bonded to the carrier material (5, 6) for increasing the rigidity, for electromagnetic shielding, cooling and/or for power supply by subsequent connection to said contact elements (2, 3), wherein the holes are prepared interferingly in the material layer in advance preferably by machining or by means of laser.

9. Process in accordance with one of the claims 1 - 8,
**characterized in that**
the top side (13) of the printed circuit board and/or the bottom side (14) of the printed circuit board are made flat, especially ground off.

10. Process in accordance with one of the claims 1 - 9,
**characterized in that**
the contact element surfaces (16, 17) exiting the printed circuit board surfaces (13, 14) are made in a shape necessary for the assembly of the various components.

11. Process in accordance with one of the claims 1 -10,
**characterized in that**
a prefabricated insulator board (7) provided with holes for the contact elements (2, 3) is used as a printed circuit board layer.

12. Process in accordance with one of the claims 1 - 11,
**characterized in that**
the contact elements are assigned such that the height of the contact elements (2, 3) exiting from the printed circuit board surface (13, 14) on both sides corresponds to the final height of the printed circuit board or, in case of contact elements exiting from the printed circuit board surface on one side only, it corresponds to a height that is smaller than the final height of the printed circuit board.

13. Process in accordance with one of the claims 1 - 12,
**characterized in that**
in the case of small dimensions, the contact elements (2, 3) are designed with an enlarged footprint (18) for the wires (8) or they are prefabricated in advance in contact element modules (20, 21).

14. Process in accordance with one of the claims 1 - 13,
**characterized in that**
three-dimensional, non-flat printed circuit boards are also manufactured by designing the casting mold accordingly.

15. Process in accordance with one of the claims 1 - 14,
**characterized in that**
the electric conductivity of the line connection is checked at the same time during the establishment of the connection performed between said associated contact elements (2, 3) by means of the wires (8).

16. Process in accordance with one of the claims 1 -15,
**characterized in that**
the connection wires of the THD components (25, 26) and the footprints of the SMD components (23, 24) are designed as contact elements.

17. Device for carrying out the process for manufacturing printed circuit boards in accordance with one of the claims 1 - 16,
**characterized in that**
a three-dimensional or more-than-three-dimensional setting machine connected to an electronic computer is provided for positioning the contact elements (2, 3) in a desired circuit pattern, wherein the working surface of the setting machine forms the bottom of the casting mold, which is open at the top, and the circumferential frame of the casting mold may be formed by edge blocks, which may be displacable or transferable especially on the working surface of the setting machine.

18. Device in accordance with claim 17,
**characterized in that**
the three-dimensional or more-than-three-dimensional setting machine has a setting arm with a positioning clamp for positioning the contact elements (2, 3) and/or with a guide clamp (9) for laying the wire or wire-writing, wherein the positioning clamp may be replaced with the guide clamp (9) on the setting arm preferably after a positioning.

## Revendications

1. Procédé de la production des plaquettes (1) écrites en fils électriques, **caractérisé par**
- l'action de verser partiellement la masse isolante (4) qui peut être durcie dans un moule qui est ouvert en haut et la taille de laquelle correspond à la forme fixée de la plaquette,
- le positionnement des éléments de contact (2, 3) préfabriqués, substantiellement également hauts et électriquement conducteurs à la fixation des composants,
- le durcissement de la masse isolante (4) à tel point que les éléments de contact, qui saillent de la masse durcie, sont fixés provisoirement,
- le positionnement des fils électriques (8) et l'établissement des connections électriques (10, 11) entre les éléments de contact (2, 3) correspondants, et les fils électriques (8) se peuvent croiser aussi souvent que l'on veut dans le cas d'une isolation propre des fils électriques, cependant limité par l'hauteur final de la plaquette et les diamètres des fils électriques utilisés, et pour un croisement des fils électriques (12) dans le cas que les fils électriques ne sont pas isolés un matériau électriquement pas conducteur, particulièrement un morceau de film plastique peut être positionné au moins dans la zone du croisement des fils électriques (12),
- le remplissage du moule avec une masse isolante (5), qui peut être durcie, jusqu'à l'hauteur final des éléments de contact (2, 3) et durcissement de la masse (fixation des fils électriques (8) et des éléments de contact (2, 3)), en tel point que la masse est versée
- sans pression ou
- par utilisation d'une plaque finale avec pression,
- l'action de retirer la plaquette durcie (1) du moule.

2. Procédé selon revendication 1,
**caractérisé en ce que**
avant l'action de verser partiellement la masse isolante (4) qui peut être durcie les éléments des contact électriquement conducteurs (2, 3) sont positionnés et le cas échéant fixés.

3. Procédé selon la revendication 2,
**caractérisé en ce que**
avant la fixation des éléments de contact (2, 3) pour une fixation provisoire des lesquelles une couche adhérente ou collante est insérée et particulièrement appliquée dons la moule, et sur la couche adhérente ou collante un plan des connections en fils électriques peut être formé.

4. Procédé selon une des revendications 1 - 3,
**caractérisé en ce que**
les éléments de contact (2, 3) sont fixés par des aimants.

5. Procédé selon une des revendications 1 - 4,
**caractérisé en ce que**
la plaquette est formée par plus d'un plans des connections en fils électriques (5, 6) qui est emballé dans une couche isolante, la quantité des lesquelles est cependant limitée par l'hauteur final de la plaquette et des diamètres utilisés.

6. Procédé selon une des revendications 1 - 5,
**caractérisé en ce que**
le positionnement des éléments de contact (2, 3) est effectué par le positionnement des éléments de contact par une machine à composer comprenant trois coordonnées ou plus, qui est reliée avec un ordinateur électronique.

7. Procédé selon une des revendications 1 - 6,
**caractérisé en ce que**
après le durcissement de la première couche isolante (4) ou un plan des connections en fils électriques (5) emballé dans un matériau isolant et avant la pose des fils électriques ou l'écriture en fils électrique une pellicule collante est vaporisée pour la mise au point du fil électrique (8).

8. Procédé selon une des revendications 1 - 7,
**caractérisé en ce que**
après la pose des fils électrique (8) d'un plan des connections en fils électrique dans le matériau porteur (5, 6) une préfabriquée couche de matériau (19), de préférence en métal, est intégrée ou positionnée ou collé qui contient les trous directs pour les éléments de contact (2, 3), pour le but d'une augmentation de la rigidité, d'un isolement électromagnétique, de refroidissement et/ou pur le but d'approvisionnement de courrant par un raccordement ultérieur avec les éléments de contact (2, 3) et les trous sont intégrés avec une taille plus grande dans la couche de matériau auparavant de préférence par faire des copeaux ou par laser.

9. Procédé selon une des revendications 1 - 8,
**caractérisé en ce que**
la surface de la plaquette (13) et/ou le dessous de la plaquette (14) sont travaillé, de préférence poncé, platement.

10. Procédé selon une des revendications 1 - 9,
**caractérisé en ce que**
le surface des éléments de contact (16, 17) qui saillent des surfaces des plaquettes (13, 14) sont formé dans une forme nécessaire pour le montage des différents components.

11. Procédé selon une des revendications 1 - 10,
**caractérisé en ce que**
une plaque de matériau isolant (7) préfabriquée avec des trous pour les éléments de contact (2, 3) est utilisée pour la couche de plaquette.

12. Procédé selon une des revendications 1 - 11,
**caractérisé en ce que**
les éléments de contact sont positionnés dans une manière que l'hauteur des éléments de contact (2, 3) saillants des deux cotés de la surface de la plaquette (13, 14) correspond avec l'hauteur final de la plaquette ou dans le cas des éléments de contact saillants seulement d'un coté de la surface de la plaquette l'hauteur de lesquels correspond avec une hauteur inférieur que l'hauteur final de la plaquette.

13. Procédé selon une des revendications 1 - 12,
**caractérisé en ce que**
dans le cas d'une taille petite les éléments de contact sont formés avec une surface de branchement (18) agrandie pour les fils électroniques (8) ou ils sont préfabriqués dans des modules des éléments de contact (20, 21) auparavant.

14. Procédé selon une des revendications 1 - 13,
**caractérisé en ce que**
aussi des plaquettes tridimensionnelles, non planes peuvent être fabriquées par le façonnage adapté de la moule.

15. Procédé selon une des revendications 1 - 14,
**caractérisé en ce que**
la conductibilité électrique est contrôlée pendant un branchement effectué entre les éléments de contact (2, 3) positionnés par les fils électriques (8).

16. Procédé selon une des revendications 1 - 15,
**caractérisé en ce que**
les fils de branchement des components THD (25, 26) ou les surfaces de branchement des components SMD (23, 24) sont formées comme éléments de contact.

17. Dispositif pour la réalisation du procédé de la fabrication des plaquettes écrites en fils électriques selon une des revendications 1 - 16,
**caractérisé en ce que**
une machine à composer comprenant trois coordonnées ou plus, qui est reliée avec un ordinateur électronique, pour le positionnement des éléments de contact (2, 3) est formé avec un modèle de circuit désiré et la surface de travaille de la machine à composer forme le fond de la moule qui est ouvert en haut et le cadre de circonférence de la moule peut être formé par des cubes de coté qui peut être glissés ou déplacés particulièrement sur la surface de travaille de la machine à composer.

18. Dispositif selon la revendication 17,
**caractérisé en ce que**
la machine à composer comprenant de trois coordonnées ou plus dispose d'un bras à composer avec une pince à positionner pour le positionnement des éléments de contact (2, 3) et/ou une pince à conduire (9) pour l'installation des fils électriques ou l'écriture en fils électriques et après le positionnement la pince à positionner est de préférence échangeable par la pince à conduire sur le bras à composer.
